Europäisches Patentamt

European Patent Office

Office européen des brevets

(19)

(11) EP 1 523 095 A1

(12) EUROPEAN PATENT APPLICATION

(43) Date of publication:
13.04.2005 Bulletin 2005/15

(51) Int Cl.⁷: H03F 3/72, H03F 3/68

(21) Application number: 03022883.7

(22) Date of filing: 08.10.2003

| | |
|---|---|
| (84) Designated Contracting States:<br>**AT BE BG CH CY CZ DE DK EE ES FI FR GB GR HU IE IT LI LU MC NL PT RO SE SI SK TR**<br>Designated Extension States:<br>**AL LT LV MK** | (72) Inventor: **Lechner, Thomas,**<br>**Sony Ericsson Mobile Comm. Int.**<br>**85609 Aschheim-Dornbach (DE)** |
| (71) Applicant: **Sony Ericsson Mobile Communications AB**<br>**221 88 Lund (SE)** | (74) Representative: **Körber, Martin, Dipl.-Phys. et al**<br>**Mitscherlich & Partner**<br>**Patentanwälte**<br>**Sonnenstrasse 33**<br>**80331 München (DE)** |

(54) **Audio output circuit**

(57) An audio output control circuit (12) is presented, which is adapted to control the output mode of a pair of audio signal outputs (13) of a mobile terminal (3) depending on the type of appliance (2) connected to the mobile terminal (3). Hereto, the pair of audio signal outputs (13) provides a first audio signal between a first terminal (a, SL) and a ground terminal (c, SG) and a second audio signal between a second terminal (b; SR) and the ground terminal (c, SG), and the audio control circuit (12) contains an audio transmission condition determination means (10) for determining the condition required for a transmission of an audio signal from the pair of audio signal outputs (13) to an appliance (2) connected to the mobile terminal (3), and an audio output configuration means (11) for configuring the output mode of the pair of audio signal outputs (13) according to a transmission condition determined by the audio transmission condition means (10), whereby the audio output configuration means (11) is adapted to provide a balanced monophonic audio signal between the first terminal (a, SR) and the second terminal (b, SL).

Figure 5a

**Description**

The present invention relates to an audio output control circuit for a mobile terminal for a wireless communication having a group of contacts for connecting the mobile terminal to a number of accessories, some of which are adapted to receive a stereophonic or monophonic audio signal from the mobile terminal via some of the contacts.

Mobile terminals like for instance mobile phones or with growing importance Personal Digital Assistants (PDAs), that combine e.g. mobile computing power with wireless communication capabilities, and other mobile appliances adapted for a wireless access to a computing and/or communication network are usually equipped with one or more groups of contacts allowing to attach an accessory like for instance a headset, a camera or the like to the mobile terminal for extending the functional range of it.

The group of contacts is particularly in PDA's and mobile phones combined to a so called system connector which allows to connect the mobile terminal to a variety of appliances of quite different functions like e.g. a charger, an earpiece, a headset, a handsfree car kit, a desk stand, a data cable, and the like. The contacts of the system connector serve as outside terminals for different functional units located within the mobile terminal. The terminal assignment of a system connector may change on some mobile terminals according to the type of appliance forming the accessory connected to the mobile terminal. The type of the respective accessory is typically identified by means of verifying an electrical characteristic accessible via two contacts or terminals, respectively, of the system connector while the appliance is connected to the mobile terminal. This enables a proper activation of the required functional units within the mobile terminal and, if necessary an adaptation of the system connector's terminal assignment. Most commonly, the electrical characteristic is given by an external voltage or resistance of a respective value which is unique for a certain kind of accessory.

As miniaturisation requires to keep the dimensions of a system connector as small as possible, the number of contacts which can be integrated in the system connector is limited. Due to this, it is not possible to provide separate ground contacts for every output and input port of a functional unit inside the mobile terminal. As the contacts of the system connector may for instance be used for connecting a power supply, transmitting control signals, serial data signals, and audio signals both from and to the mobile terminal, some of the respective ports share a common ground terminal. As a result, the return currents of one or more ports combine over the common ground defined by the shared ground terminal pin.

The contact resistance of a ground terminal pin causes a considerable voltage drop for large return currents. This voltage drop caused by one port adds up to a signal voltage of another port using the same ground terminal and corrupts the signals transmitted over this other port. As an example, a system connector may have only two ground contacts, one forming a common ground for outgoing and incoming audio signals and the other shared by all digital signal and control signal ports and a power supply.

If a port on the system connector used for outgoing audio signals shares a common ground terminal pin with a port for incoming audio signals, the outgoing audio signal may provide a high current e.g. for driving the earphone of a headset or for supplying the low input impedance of a handsfree car kit. The audio signal provided at the port for incoming audio signals is usually generated by a microphone that typically produces a signal of low voltage level. The voltage drop at the shared ground terminal caused by the return current of the outgoing audio signal thus produces a not to be ignored crosstalk on the audio input port of the system connector. When both audio ports are used within a wireless communication, the crosstalk will be audible as an echo signal on the far end of the connection.

In case of an audio port sharing a common ground terminal with a switched mode power supply or a digital signal port at the same time, any AC-component of the power supply or the digital signal port causes a crosstalk signal at the audio port which will be perceived as noise.

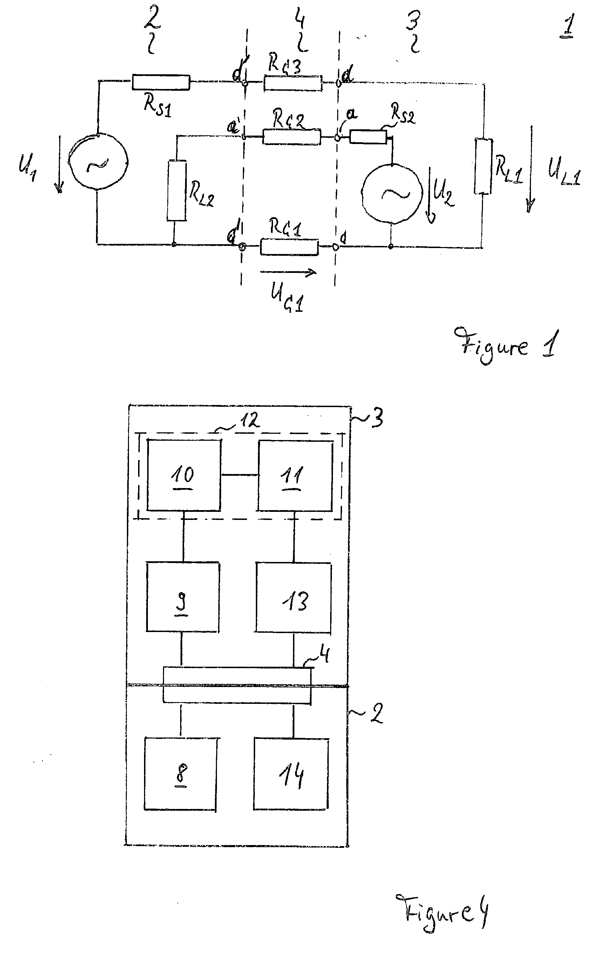

The crosstalk problem arising from a common ground shared by an outgoing and an incoming audio port is illustrated in Figure 1. A microphone in an accessory kit is assumed to produce a input signal voltage $U_1$ and the audio output stage of the mobile terminal connected to it likewise an outgoing audio signal of voltage $U_2$. The two audio ports share a common ground terminal pin showing a contact resistance of value $R_{C1}$. The contact resistance of the non-ground terminal of the outgoing audio port is $R_{C2}$ and that of the incoming audio port is $R_{C3}$. $R_{L1}$ is the input impedance of the audio-in circuitry of the mobile terminal and $R_{L2}$ is the impedance of the transducer or amplifier input in the accessory kit. The voltage drop across $R_{L1}$ is then given by the equation:

$$U_{L1} = U_1 \cdot \frac{R_{L1}}{R_{S1}+R_{L1}+R_{C1}+R_{C3}} + U_2 \cdot \frac{R_{C1}}{R_{S2}+R_{L2}+R_{C1}+R_{C2}}; \qquad (1)$$

whereby the second term

$$\left( U_2 \cdot \frac{R_{C1}}{R_{S2} + R_{L2} + R_{C1} + R_{C2}} \right)$$

defines the crosstalk of the audio output signal into the audio input signal line.

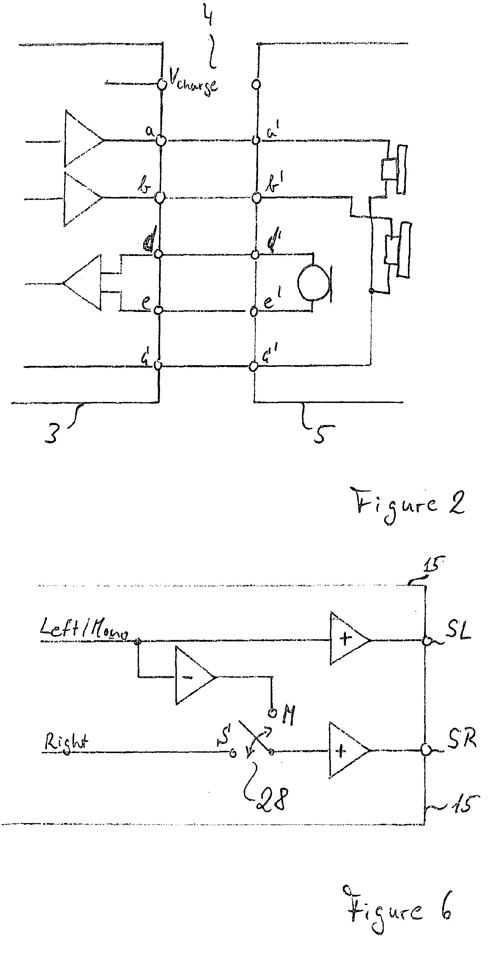

Modern mobile terminals provide stereophonic audio output capabilities. Some appliances which can be connected to a respective mobile terminal are adapted to support a corresponding stereo reproduction of the audio output signals, others are restricted to a monophonic operation only. According to the described above, a separate ground is required for the stereo output port as well as for the audio input port as shown in Figure 2 for to avoid any crosstalk between the two audio ports. The same applies to sharing a ground terminal with a data or power supply port. This is opposed to the requirement of integrating all the terminals necessary for a multitude of input and output ports in one system connector allowing only a limited number of contact pins.

The functional extension of a mobile terminal with various accessories requires the provision of additional input and output ports, each of which uses one or more ground potential terminals or contact pins, respectively. With the limited number of pins available in the system connector, not enough separate ground terminals can be provided. A multiple assignment of a ground terminal by several input and/or output ports therefore is the usual case. As this inevitably results in a crosstalk between the ports, an audio signal transmitted via a port sharing a common ground with other ports can generally only be reproduced with a poor fidelity.

It is now an object of the present invention to provide a monophonic audio output port configuration for mobile terminals with a stereo audio output port which is free of any crosstalk from other ports of the mobile terminal using the two signal terminals of the stereo audio output port.

This object is achieved by the invention as defined in the independent claim.

It proposes an audio output control circuit which is adapted to control the output mode of a pair of audio signal outputs of a mobile terminal depending on the type of appliance connected to the mobile terminal. Hereto, the pair of audio signal outputs provides a first audio signal between a first terminal and a ground terminal, and a second audio signal between a second terminal and the ground terminal, and the audio control circuit contains an audio transmission condition determination means for determining the condition required for a transmission of an audio signal from the pair of audio signal outputs to an appliance connected to the mobile terminal, and an audio output configuration means for configuring the output mode of the pair of audio signal outputs according to a transmission condition determined by the audio transmission condition means, whereby the audio output configuration means is adapted to provide a balanced monophonic audio signal between the first terminal and the second terminal.

The present invention thus advantageously enables a ground potential free transmission of audio signals via a system connector, so that the respective audio port does not require a ground terminal that might have to be shared with a further port.

Further advantageous features of the present invention are claimed in the respective subclaims.

When the audio signal is already prepared as a single ended monophonic first audio signal, the balanced monophonic audio signal is effectively formed of the first audio signal and the inverted first audio signal. The same is applicable to a single ended monophonic second audio signal provided.

If only a single ended stereophonic audio signal is provided, the audio output configuration means preferably forms the balanced monophonic audio signal by adding the first audio signal and the second audio signal. The sum is hereby output directly on the first terminal (a, SL) and inverted on the second terminal (b, SR) of the pair of audio signal outputs (13).

According to an advantageous development, the audio output configuration means comprises a switching means adapted to alternate the circuit arrangement of the voiceband electronic circuit according to a transmission condition determined by the audio transmission condition determination means.

In a further preferred embodiment, the pair of audio signal outputs is formed by a voiceband electronic circuit with a first output port for the first audio signal and a second output port for the second audio signal, and the audio output configuration means is adapted to selectively process an audio signal provided at a non-ground terminal of an output port of the voiceband electronic circuit and to supply the respective processed audio signal to a terminal of the pair of audio signal outputs which is selected according to a transmission condition determined by the audio transmission condition determination means.

Hereby the audio output configuration means effectively comprises a DC-level detection means for detecting the DC-level at the non-ground terminal of each output port of the voiceband electronic circuit, whereby the DC-level is defined by the level of the DC component of an audio signal provided at the respective output port, and the audio output configuration means further comprises a switching arrangement controlling the signal routing between a non-ground terminal of an output port of the voiceband electronic circuit and one or more terminals of the pair of audio signal outputs according to a level of the DC component detected at the non-ground terminal of each output port. The

**EP 1 523 095 A1**

switching arrangement hereby preferably breaks off a signal path connecting the non-ground terminal of an output port of the voiceband electronic circuit to a terminal of the pair of audio signal outputs on the condition of the DC-level at that terminal being below a threshold value.

Further, if the DC-level detection means detects a DC-level at the non-ground terminal of the first output port of the voiceband electronic circuit above the threshold value and a DC-level at the non-ground terminal of the second output port of the voiceband electronic circuit below the threshold value, the audio signal provided at the non-ground terminal of the first output port is on the one hand suitably forwarded to the first terminal of the stereophonic audio circuit stage with the pair of audio signal outputs, and on the other hand inverted prior to being additionally forwarded to the second terminal (SR) of the pair of audio signal outputs. And, if further the DC-level detection means detects a DC-level above a threshold value on the non-ground terminals of the first as well as the second output port of the voiceband electronic circuit, the audio signal provided on the non-ground terminal of the first output port is suitably forwarded to the first terminal of the pair of audio signal outputs, and the audio signal of the non-ground terminal of the second output port is forwarded to the second terminal of the pair of audio signal outputs.

The DC-level is effectively obtained by low pass filtering the audio signal but can also advantageously be controlled by a state detection circuit comprising an audio signal level detector followed by a short-term signal level bridge.

In the following description, the present invention is explained in more detail with respect to special embodiments and in relation to the enclosed drawings, in which

Figure 1    shows an equivalent circuit diagram for illustrating the crosstalk problem for two signal ports sharing a common ground contact,

Figure 2    shows the port configuration for a system connector providing a single ended stereophonic output port and a single ended monophonic audio input port,

Figure 3a    shows an output port configuration according to the present invention for use with a monophonic headset,

Figure 3b    shows an output port configuration according to the present invention for use with a handsfree car kit,

Figure 4    shows a schematic circuit diagram of a mobile terminal with an audio control circuit according to the present invention,

Figure 5a    shows a first embodiment of an output control circuit according to the present invention,

Figure 5b    shows a second embodiment of an output control circuit according to the present invention,

Figure 5c    shows the timing diagram for the state detection unit used in the embodiment of Figure 5b, and

Figure 6    shows an output stage of a voiceband electronic circuit according to a third embodiment of the present invention

The equivalent circuit 1 for a monophonic headset 2 connected to the respective audio circuits of a mobile terminal 3 by means of a system connector 4 with finite contact resistances $R_{C1}$, $RC_2$, and $R_{C3}$ is shown in Figure 1. The headset 2 includes a microphone acting as a voltage signal source $U_1$ with a source impedance $R_{S1}$ and an earphone shown as load $R_{L2}$. The audio output stage of the mobile terminal 3 produces an audio output signal voltage $U_2$ which is supplied to the earphone $R_{L2}$ via a port formed by the contacts a-a' and c-c'. The respective signal source $U_2$ shows a source impedance $R_{S2}$. The audio input circuitry of the mobile phone 3 has the input impedance $R_{L1}$ to which the microphone signal $U_1$ is applied via the port formed by the contact d-d' and c-c' of the system connector 4. Each contact of the system connector 4 has its individual contact resistance, that is $R_{C1}$ for the common-ground terminal c-c', $R_{C2}$ for the audio-out terminal a-a', and $R_{C3}$ for the audio-in terminal d-d'. As can be seen from the mesh equation (1), the voltage drop $U_{L1}$ is not only caused by the microphone signal $U_1$ but also by the voltage drop across the contact resistance $R_{C1}$ of the common ground terminal c-c'. As U, is typically much smaller than $U_2$, the portion of $U_2$ contributing to $U_{L1}$ is typically not to be ignored.

With reference to Figure 2 a mobile terminal 3 connected to a stereo headset 5 with a monophonic microphone is shown. To avoid any crosstalk between the single ended stereophonic audio output port formed by the contacts a-a', b-b', and c-c' and the likewise single ended monophonic audio input port formed by the contacts d-d' and e-e', both audio ports use their own separate ground contacts c-c' and e-e', respectively. As long as no further ports requiring one of the ground terminals c or e are needed, this configuration imposes no problem.

**4**

But many appliances as for instance a low range wireless headset attachment or a handsfree car kit require additional ports for to a transmit e.g. a supply voltage and/or digital signals which will occupy one of the ground terminals, e.g. the c terminal as shown. Even if only a monophonic audio signal is required, the common ground terminal will result in a crosstalk between the ports sharing the common ground and thus impair the quality of an audio signal transmission over the system connector.

As the crosstalk is induced by the contact resistance of the common ground terminal, the present invention provides an audio output signal configuration which can be implemented in the system connector without using a ground terminal. This is achieved by providing a balanced monophonic audio output signal at non-ground terminals of the system connector when an appliance requires only a monophonic audio output signal from the mobile terminal 3. In contrast to a single ended monophonic audio output port, i.e. an audio port providing the signal between a non-ground terminal (e.g. a-a') and a ground terminal (e.g. c-c'), no voltage drop across a ground terminal contact resistance has to be considered and thus no crosstalk into the audio port will occur.

As some accessory kits like a passive stereo headset 5 require two audio channels, three contacts, in the example of Figure 2 the three contacts a-a', b-b', and c-c' are needed for the stereo audio signal transmission. If the common ground terminal c-c' is further used for other signals, the AC-component of these signals should be extremely small. With the present invention, the monophonic audio signal required for other accessories is provided with a ground-free balanced audio signal instead of a single ended one using just one channel of the pair of audio signal outputs.

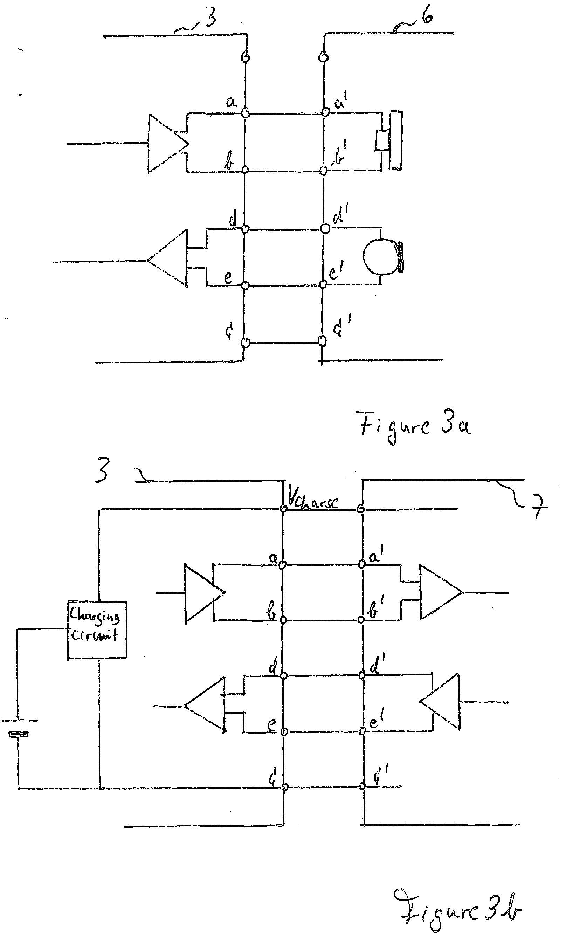

This is accomplished by an audio output control circuit which for one verifies if an accessory connected to the mobile terminal requires only a monophonic audio output signal and if so, controls the output mode of the pair of audio signal outputs to provide a balanced monophonic audio signal between the non-ground terminals a-a' and b-b' of the pair of audio signal outputs. This is illustrated in the schematic circuit diagrams of Figure 3a for an accessory monophonic headset, and in Figure 3b for an accessory handsfree car kit.

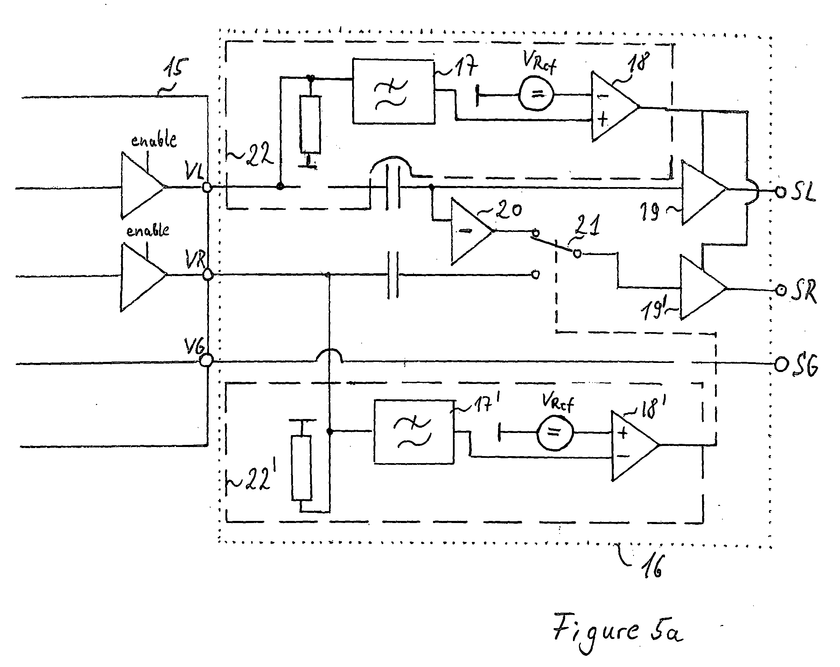

Figure 4 shows an accessory kit 2 with an audio unit 14 connected to a mobile terminal 3. It is to be noted that only those functional units which are relevant for the understanding of the present invention are shown in Figure 4 and that other units like for instance the circuitry used for a wireless communication, a processing and storage capability or the like which are important for the working of a mobile terminal have been omitted the for the sake of a clear and easy understandable representation. The accessory device 2 comprises an identification unit 8 by which the appliance identifier 9 of the mobile terminal is able to identify the type of the respective appliance kit 2 according to what has been explained above. The audio unit 14 of the appliance 2 is connected to the pair of audio signal outputs 13 via contacts of the system connector 4.

The type identification obtained by the appliance identifier 9 is used by the audio transmission condition determination means 10 for determining the condition required for a transmission of an audio signal from the pair of audio signal outputs 13 to the accessory audio unit 14. This is best achieved by consulting a list available on a storage medium on the mobile terminal which assigns each accessory type information about the nature of its audio unit 14.

On the basis of the type of audio unit 14 present in the accessory kit 2 as determined by the audio transmission condition determination means 10, the audio output configuration means 11 configures the output mode of the pair of audio signal outputs such, that a single ended stereophonic audio output signal is provided at respective terminal pins of the system connector 4 when the audio unit 14 requires a provision of a stereophonic audio signal. Else, and a balanced monophonic is provided. The balanced monophonic audio signal is hereby provided between the non-ground terminals of the pair of audio signal outputs. The location of the respective terminal pins must hereby not be fixed within the system connector but may be varied in relation to an appliance 2 connected to the mobile terminal 3. The audio transmission condition determination means 10 and the audio output configuration means 11 together form the audio output control circuit 12.

The output mode of a pair of audio signal outputs 13 of a mobile terminal 3 can be modified in various ways. The audio signals to be provided at an output port of the mobile terminal 3 are usually provided by a voiceband electronic circuit comprising one or more audio outputs that can be activated or deactivated according to a required application. Usually one of the audio outputs is reserved for the left channel and another one for the right channel of a stereophonic audio signal. A monophonic signal is either presented to the left or on the right channel. For operating the voiceband electronic circuit in monophonic mode, the respective channel is turned on while the other is turned off.

In the "Off" state, the electric impedance of an audio output is high with its electric potential set to ground. In the "On" state, the DC potential at an audio output is about half that of the power supply voltage for the voiceband electronic circuit and the audio output shows a low impedance, i.e. in the range of a few ohm or less.

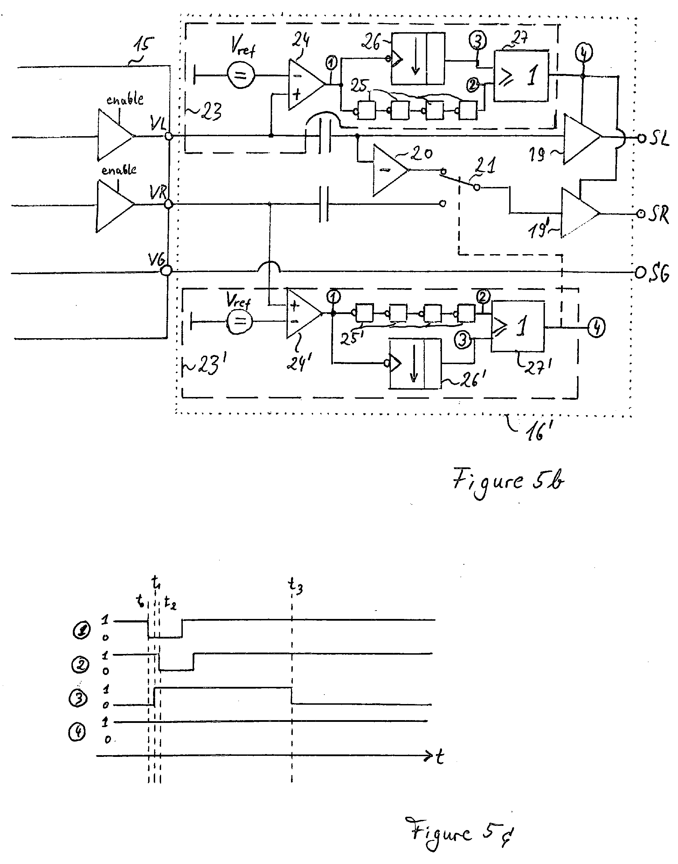

According to a first embodiment of the present invention, the audio output configuration means 11 comprises an automatic audio line configurator 16 which is placed between the audio outputs VL and VR of the voiceband electronic circuit 15 and the audio terminals SL and SR of the system connector 4 as shown in Figures 5a and 5b. The automatic audio line configurator 16 is able to detect the operation mode of the voiceband electronic circuit 15. When the voiceband electronic circuit works in stereo mode, the stereophonic audio signal provided is directly routed to the audio port of the system connector. When the audio output configuration means 11 switches the voiceband electronic circuit 15 in mono mode, the single ended monophonic audio signal provided at one channel of the voiceband electronic circuit is transformed into a balanced monophonic audio signal before being supplied to the terminals SL and SR of the system connector audio port.

Assumed a monophonic audio signal is only provided at the left channel of the voiceband electronic circuit 15 between the terminals VL and VG as shown in Figures 5a and 5b, a balanced monophonic audio signal at the terminals SL and SR of the system connector 4 can be achieved by applying the signal present at VL to SL and the inverted signal present at VL to SR or vice versa.

The automatic audio line configurator 16 shown in Figure 5a contains a state detection unit 22 and 22', respectively, for each audio output of the voiceband electronic circuit 15. Each of the two state detection units is formed by a low pass filter 17 or 17', respectively, followed by a comparator 18 or 18', respectively. The low pass filter 17 (17') isolates the DC potential at an audio output VL or VR, respectively, and passes it to the comparator where it is compared with a reference voltage $V_{ref}$. If an audio output of the voiceband electronic circuit is in the "On" state, the DC potential is higher than that of the reference voltage $V_{ref}$.

For a sufficiently high DC potential at the left channel of the voiceband electronic circuit 15, i.e. usually about half the supply voltage for the voiceband electronic circuit, the state detection unit for the left channel turns on both output line amplifiers 19 and 19'. This means, that if the left channel of the voiceband electronic circuit is in the "On" state, an audio signal can be supplied to both channels of the audio port of the system connector independent of the type of audio signal.

For the right channel being in the "Off" state, its DC potential is below the reference voltage $V_{ref}$. In consequence, the output voltage of the comparator 18' enforces the balancing switch 21 to connect the output of the inverter 20 with the input of the output line amplifier 19' and to disconnect the input of the output line amplifier 19' from the audio output terminal VR of the voiceband electronic circuit 15. In this case, a balanced monophonic audio signal is provided between the terminals SL and SR of the system connector 4.

When the right channel of the voiceband electronic circuit 15 is in the "On" state, its DC potential is above the reference voltage $V_{ref}$. The output voltage of the comparator 18' now enforces the balancing switch 21 to disconnect the input of the output line amplifier 19' from the inverter 20 and to connect it to the line from the right channel terminal VR of the voiceband integrated circuit 15. In this case, the left channel audio signal is provided between the terminals VL and VG, and the right channel audio signal is provided between the terminals VR and VG of the system connector 4.

In the third case, when both audio outputs VL and VR of the voiceband electronic circuit 15 are in the "Off" state, the terminals SL and SR of the system connector are set on ground potential or high output impedance.

In Figure 5b an automatic audio line configurator 16' using state detection units 23 and 23' of an alternative embodiment is shown. In contrast to the detection units 22 and 22' , the audio signal from an audio output VL or VR of the voiceband electronic circuit 15 is compared directly to the reference voltage $V_{ref}$ by the respective comparator 24 or 24' thus forming a real time audio signal level detector. If the AC component of the audio signal is of a high amplitude, the audio signal level may temporarily fall below the reference voltage level although the DC component of the audio signal is still above the reference level indicating the respective audio output to be in the "On" state. To prevent the state detection units 23 and 23' from producing a correspondingly faulty output voltage, the output signal of the comparator 24 (24') is distributed to a short-term signal level bridge formed by a monoflop 26 (26') in parallel to a serial connection of inverters 25 (25') and an OR gate 27 (27') combining the output of the inverter line with that of the monoflop 26 (26').

The function of the thus formed short-time signal drop detection is explained with respect to the time diagram of Figure 5c and to the particular state detection unit 23 used for evaluating the state of the VL audio output. Assumed, the audio signal level drops below $V_{ref}$, then the output voltage of the comparator 24 drops from a high to a low level as indicated by signal line ① in Figure 5c for the time $t_o$. The output of an inverter 25 reacts with a delay in the order of less than a millisecond to a change at its input. The delays sum up with the number of inverters used in the delay line. As only an even number of inverters is used, the signal level at last inverter of the chain corresponds to that at the output of the comparator 24, but follows any change in the comparator output with a delay in the lower millisecond range. Assumed that the level of the audio signal will be short of $V_{ref}$ for about 5 ms, than the level at the output of the comparator 24 will also be low for that 5 ms, but the output of the last inverter 25 follows the comparator output with a short delay of $t_2-t_0$ as shown by signal line ② in Figure 5c. The output of the monoflop 26 changes to a high level for the output level of the comparator 24 changing to a low level. The delay $t_1-t_0$ of the comparator output is shorter than that of the line of inverters 25. The monoflop 26 keeps the high output level for about 200 ms until time $t_3$. The respective output level behaviour is shown as line ③ in Figure 5c. When the level of the audio signal returns above the reference voltage level $V_{ref}$ within that 200 ms, either the output level at the last inverter 25 of the delay line and/ or of the monoflop 26 is high, which means the output level of the OR gate (line (1)) maintains a high level which is correct for indicating the respective audio output of the voiceband electronic circuit 15 to be in the "On" state. Only when the audio signal falls below the reference voltage $V_{ref}$ for a time period longer than the dwell time of the monoflop 26, the state detection unit 23 will indicate an "Off" state for the respective audio output by providing a low output level at the output port of the OR gate 27. Thus a shorter switch-on reaction time is achieved than with a state detection unit 22 and 22'.

In a further embodiment of the present invention, the audio output control circuit 12 is implemented by a switching array within the voiceband electronic circuit 15, whereby the switching array is controlled by a logic unit of the audio output configuration means 11 for modifying the circuit arrangement of the voiceband electronic circuit 15 according to the audio output mode determined by the audio transmission condition determination means 10. The individual switches of the switching array are typically formed by one or more electronic devices like a transistor or the like as these kind of devices can easily be controlled by a logic circuitry. The voiceband electronic circuit 15 contains a series of audio amplifiers which can be interconnected by the switches of the switching array. This is schematically illustrated in Figure 6 showing the switching element 28 enabling an interconnection of the SR audio output of the voiceband integrated circuit 15 to the inverted signal of the internal left channel line of the voiceband electronic circuit when a balanced monophonic audio signal is to be produced, and a direct interconnection of the SR audio output to the internal right channel line for producing a stereophonic audio output signal.

In a further preferred embodiment of the present invention, the balanced monophonic audio signal is achieved by adding the right channel with the left channel audio signal. The sum of both channels is hereby directly output to the first terminal SL of the pair of audio signal outputs 13 and inverted to the second terminal SR of the pair of audio signal outputs 13.

## Claims

1. Audio output control circuit (12) for controlling the output mode of a pair of audio signal outputs (13) of a mobile terminal (3) depending on the type of appliance (2) connected to the mobile terminal (3), with the pair of audio signal outputs (13) providing a first audio signal between a first terminal (a, SL) and a ground terminal (c, SG) and providing a second audio signal between a second terminal (b, SR) and the ground terminal (c, SG), and the audio control circuit (12) comprising

   - audio transmission condition determination means (10) for determining the condition required for a transmission of an audio signal from the pair of audio signal outputs (13) to an appliance (2) connected to the mobile terminal (3), and
   - audio output configuration means (11) for configuring the output mode of the pair of audio signal outputs (13) according to a transmission condition determined by the audio transmission condition means (10),

   **characterised in**
   **that** the audio output configuration means (11) is adapted to provide a balanced monophonic audio signal between the first terminal (a, SL) and the second terminal (b, SR).

2. Audio output control circuit according to claim 1,
   **characterised in**
   **that** the balanced monophonic audio signal is formed of the first audio signal and the inverted first audio signal.

3. Audio output control circuit according to claim 1,
   **characterised in**
   **that** the balanced monophonic audio signal is formed of the first audio signal added with the second audio signal, with the sum being directly output on the first terminal (a, SL) and invertedly output on the second terminal (b, SR) of the pair of audio signal outputs (13).

4. Audio output control circuit according to one of the claims 1 to 3,
   **characterised by**
   the audio output configuration means (11) comprising a switching means (28) for alternating the circuit arrangement of the voiceband electronic circuit according to a transmission condition determined by the audio transmission condition determination means (10).

5. Audio output control circuit according to one of the claims 1 to 3,
   **characterised by**
   the pair of audio signal outputs (13) comprising a voiceband electronic circuit (15) with a first output port (VL-VG) for the first audio signal and a second output port (VR-VG) for the second audio signal, and the audio output configuration means (11) being adapted to selectively process an audio signal provided at a non-ground terminal (VL, VR) of an output port (VL-VG, VR-VG) of the voiceband electronic circuit (15) and to supply the respective processed audio signal to a terminal (SL, SR) of the pair of audio signal outputs (13) being selected according to a transmission condition determined by the audio transmission condition determination means (10).

**6.** Audio output control circuit according to claim 5,
**characterised in**
**that** the audio output configuration means (11) comprises

- a DC-level detection means (22, 22', 23, 23') for detecting the DC-level at the non-ground terminal (VL, VR) of each output port (VL-VG, VR-VG) of the voiceband electronic circuit (15), whereby the DC-level is defined by the level of the DC component of an audio signal provided at the respective output port (VL-VG, VR-VG), and
- a switching arrangement (19, 19', 21, 22, 22', 23, 23') controlling the signal routing between a non-ground terminal (VL, VR) of an output port (VL-VG, VR-VG) of the voiceband electronic circuit (15) and one or more terminals (SL, SR) of the pair of audio signal outputs (13) according to a level of the DC component detected at the non-ground terminal (VL, VR) of each output port (VL-VG, VR-VG).

**7.** Audio output control circuit according to claim 6,
**characterised in**
**that**, if the DC-level at the non-ground terminal (VL, VR) of an output port (VL-VG, VR-VG) of the voiceband electronic circuit (15) is below a threshold value ($V_{ref}$), the switching arrangement (19, 19', 21, 22, 22', 23, 23') breaks off a signal path connecting said terminal (VL, VR) to a terminal (SL, SR) of the pair of audio signal outputs (13).

**8.** Audio output control circuit according to claim 7,
**characterised in**
**that**, if the DC-level detection means (22, 22', 23, 23') detects a DC-level at the non-ground terminal (VL) of the first output port (VL-VG) of the voiceband electronic circuit (15) above the threshold value ($V_{ref}$) and a DC-level at the non-ground terminal (VR) of the second output port (VR-VG) of the voiceband electronic circuit (15) below the threshold value ($V_{ref}$), the audio signal provided at the non-ground terminal (VL) of the first output port (VL-VG) is on the one hand forwarded to the first terminal (SL) of the pair of audio signal outputs (13) and on the other hand inverted prior to being additionally forwarded to the second terminal (SR) of the pair of audio signal outputs (13).

**9.** Audio output control circuit according to claim 7,
**characterised in**
**that**, if the DC-level detection means (22, 22' , 23, 23') detects a DC-level above a threshold value on the non-ground terminals (VL, VR) of the first (VL-VG) as well as the second (VR-VG) output port of the voiceband electronic circuit (15), the audio signal provided on the non-ground terminal (VL) of the first output port (VL-VG) is forwarded to the first terminal (SL) of the pair of audio signal outputs (13) and the audio signal of the non-ground terminal (VR) of the second output port (VR-VG) is forwarded to the second terminal (SR) of the pair of audio signal outputs (13).

**10.** Audio output control circuit according to one of the claims 6 to 9,
**characterised in**
**that** the DC-level is obtained by a low pass filtering of the audio signal.

**11.** Audio output control circuit according to one of the claims 6 to 9,
**characterised in**
**that** the DC-level is controlled by a state detection circuit (23, 23') comprising an audio signal level detector (24, 24') followed by a short-term signal level bridge (25,26, 25', 26').

Figure 1

Figure 4

Figure 2

Figure 6

Figure 3a

Figure 3.b

Figure 5a

Figure 5b

Figure 5c

**European Patent Office**

## EUROPEAN SEARCH REPORT

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | EP 0 310 575 A (SGS THOMSON MICROELECTRONICS) 5 April 1989 (1989-04-05) * the whole document * --- | 1,2,4-11 | H03F3/72 H03F3/68 |
| X | US 4 494 077 A (FUKAYA HIROKAZU  ET AL) 15 January 1985 (1985-01-15) * column 1, line 1 - column 4, line 16; figures 1-3 * ----- | 1-5 | |

| | | | TECHNICAL FIELDS SEARCHED (Int.Cl.7) |
|---|---|---|---|
| | | | H03F |

The present search report has been drawn up for all claims

| Place of search | Date of completion of the search | Examiner |
|---|---|---|
| THE HAGUE | 17 March 2004 | Pantelakis, P |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

....................................................................................

& : member of the same patent family, corresponding
   document

EPO FORM 1503 03.82 (P04C01)

**ANNEX TO THE EUROPEAN SEARCH REPORT
ON EUROPEAN PATENT APPLICATION NO.**

EP 03 02 2883

This annex lists the patent family members relating to the patent documents cited in the above-mentioned European search report.
The members are as contained in the European Patent Office EDP file on
The European Patent Office is in no way liable for these particulars which are merely given for the purpose of information.

17-03-2004

| Patent document cited in search report | | Publication date | Patent family member(s) | | Publication date |
|---|---|---|---|---|---|
| EP 0310575 | A | 05-04-1989 | IT | 1214255 B | 10-01-1990 |
| | | | DE | 3886649 D1 | 10-02-1994 |
| | | | DE | 3886649 T2 | 21-04-1994 |
| | | | EP | 0310575 A2 | 05-04-1989 |
| | | | JP | 1109910 A | 26-04-1989 |
| | | | US | 4879526 A | 07-11-1989 |
| US 4494077 | A | 15-01-1985 | JP | 1059762 B | 19-12-1989 |
| | | | JP | 1588884 C | 19-11-1990 |
| | | | JP | 58153408 A | 12-09-1983 |
| | | | JP | 58095412 A | 07-06-1983 |
| | | | US | 4596957 A | 24-06-1986 |

EPO FORM P0459

For more details about this annex : see Official Journal of the European Patent Office, No. 12/82